(19) **Europäisches Patentamt**
**European Patent Office**
**Office européen des brevets**

(11) **EP 1 672 795 B1**

(12) **FASCICULE DE BREVET EUROPEEN**

(45) Date de publication et mention
de la délivrance du brevet:
**08.10.2008 Bulletin 2008/41**

(51) Int Cl.:
***H03K 17/22*** *(2006.01)*

(21) Numéro de dépôt: **05111396.7**

(22) Date de dépôt: **28.11.2005**

(54) **Dispositif de réinitialisation d'un circuit intégré à partir d'une détection d'une chute d'une tension d'alimentation, et circuit électronique correspondant**

Vorrichtung zur Reinitialisierung eines integrierten Schaltkreises anhand der Detektion eines Spannungsabfalls der Stromversorgung und elektrische Schaltung hierfür

Device for reinitialization of an integrated circuit issued from a power supply fail detection, and associated electronic circuit

(84) Etats contractants désignés:
**DE ES GB IT NL**

(30) Priorité: **15.12.2004 FR 0413375**

(43) Date de publication de la demande:
**21.06.2006 Bulletin 2006/25**

(73) Titulaire: **ATMEL NANTES SA**
**44306 Nantes Cédex 3 (FR)**

(72) Inventeur: **Messager, Philippe**
**44300 Nantes (FR)**

(74) Mandataire: **Guéné, Patrick Lucien Juan Joseph**
**Cabinet Vidon**
**Technopole Atalante**
**16B, rue de Jouanet**
**BP 90333**
**F-35703 Rennes Cedex 7 (FR)**

(56) Documents cités:
**US-A- 5 910 739**      **US-A1- 2004 066 218**
**US-B1- 6 515 523**

**Description**

**1. Domaine de l'invention**

Le domaine de l'invention est celui des circuits électroniques intégrés et plus particulièrement celui des circuits du type comprenant des composants électroniques équipés d'une entrée de réinitialisation (« reset », en anglais), tels que les portes logiques, les bascules, les mémoires ou encore les microprocesseurs.

Plus précisément, l'invention concerne la génération d'un signal de réinitialisation pour de tels circuits.

**2. Solutions et inconvénients de l'art antérieur**

Par souci de simplification de la description, on se limitera, dans toute la suite de ce document, à décrire le cas particulier des circuits intégrés fonctionnant sous une tension d'alimentation de 3V. L'Homme du Métier étendra sans difficulté cet enseignement à tout type de tension destinée à alimenter un circuit électronique intégré.

Généralement, les circuits intégrés fonctionnent avec une tension d'alimentation qui n'est pas parfaitement stable, ce qui cause parfois de sérieux dégâts lorsque la tension d'alimentation chute à un niveau très faible. En effet, un microprocesseur sous alimenté peut avoir, par exemple, un fonctionnement aléatoire suivant lequel il peut écrire des données corrompues dans une mémoire ou écraser des programmes, provoquant ainsi une panne du système lorsque la tension d'alimentation redevient suffisante.

Il est donc classique qu'un circuit intégré comprenne un détecteur de chute d'alimentation (ou PFD, pour « Power Fail Detector » en anglais) (aussi appelé dispositif de réinitialisation dans la suite de la description) qui permet, après une détection d'une chute d'une tension d'alimentation, de générer un signal de réinitialisation afin d'interdire le fonctionnement de la logique, des mémoires ou encore des microprocesseurs, jusqu'au rétablissement d'une tension d'alimentation suffisante.

Le document de brevet US 6,515,523 décrit un dispositif de réinitialisation, du type Power On Reset, présentant un premier mode de fonctionnement correspondant au fonctionnement habituel de réinitialisation, c'est-à-dire qu'on réinitialise le(s) circuit(s) tant que la tension d'alimentation n'a pas atteint un niveau suffisant, et un second mode de fonctionnement, correspondant à un fonctionnement du type Power Fail Detector, permettant de détecter une chute de la tension d'alimentation, et le cas échéant de générer le signal de réinitialisation.

Un inconvénient majeur de cette technique de l'art antérieur réside dans le fait qu'elle utilise une tension générée en sortie d'un amplificateur différentiel pour activer des moyens de génération d'un signal de réinitialisation. En conséquence, lorsque la tension d'alimentation devient insuffisante pour assurer le fonctionnement de l'amplificateur différentiel aucun signal de réinitialisation n'est générée.

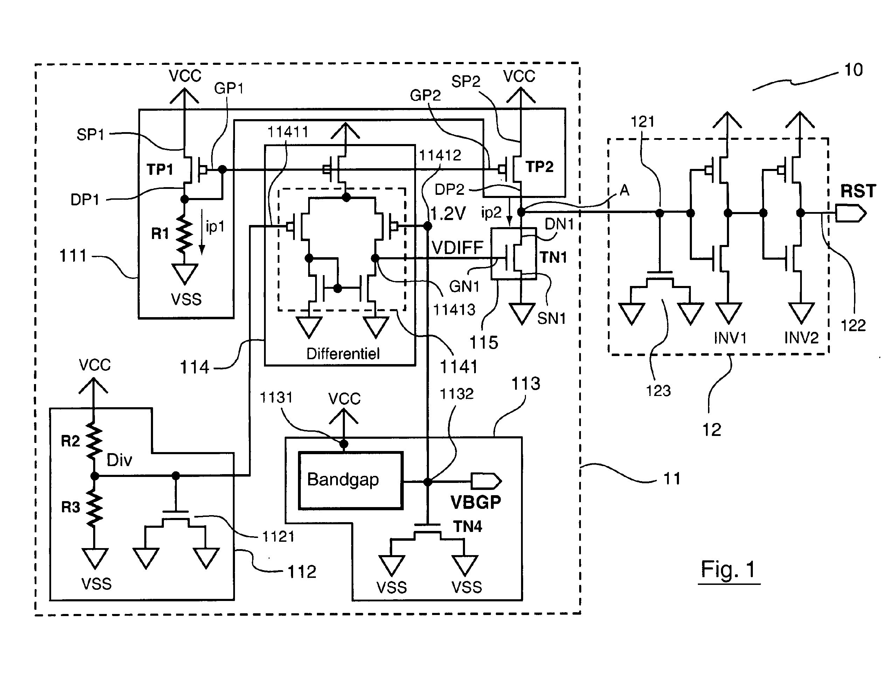

La figure 1 présente le schéma d'un exemple de détecteur de chute d'alimentation (PFD) classique, référencé 10.

Dans le cas particulier de cette figure, un amplificateur différentiel 1141 qui est alimenté par une tension d'alimentation VCC, reçoit sur une première entrée 11411 une tension qui est proportionnelle à la tension d'alimentation VCC, appelée tension pondérée div, et reçoit sur une seconde entrée 11412 une tension de référence VBGP. L'amplificateur différentiel 1141 délivre en sortie 11413 une tension résultante VDIFF qui est fonction du résultat de la comparaison de la tension pondérée div avec la tension de référence VBGP. La tension résultante VDIFF est directement appliquée sur la grille GN1 d'un transistor TN1. Le transistor TN1, dont la source SN1 est reliée au potentiel de référence VSS et dont le drain DN1 est relié à une source de courant 111, est utilisé comme un interrupteur 115 permettant, en fonction de la valeur de la tension résultante VDIFF, d'activer ou non des moyens de génération 12 d'un signal de réinitialisation RST.

Dans cette solution, les moyens de génération 12 sont activés lorsque la tension d'alimentation VCC de 3V chute en dessous d'un seuil prédéterminé de 2,4V. En effet, lorsque la tension d'alimentation VCC est inférieure à 2,4V, la tension pondérée div, dont la valeur est égale à la moitié de la tension d'alimentation VCC, est inférieure à la tension de référence VBGP de 1,2V. L'amplificateur différentiel 1141 délivre donc en sortie 11413 une tension résultante VDIFF qui est sensiblement égale au potentiel de référence VSS, soit 0V, et qui permet ainsi de placer le transistor TN1 dans un état bloquant (interrupteur ouvert), dans lequel il dirige le courant ip2 de la source de courant 111 vers les moyens de génération 12, de façon à activer la génération d'un signal de réinitialisation RST.

Le détecteur de chute d'alimentation (PFD) 10 coopère généralement avec un dispositif auxiliaire d'activation (non représenté) des moyens de génération 12 d'un signal de réinitialisation RST. Ce dispositif auxiliaire d'activation (ou POR, pour « Power On Reset » en anglais) est typiquement réalisé au moyen d'un filtre RC et permet, à la mise sous tension du détecteur de chute d'alimentation (PFD) 10, d'activer pendant un délai déterminé les moyens de génération 12, jusqu'à ce que la tension d'alimentation VCC remonte à un niveau suffisant (>1,3V) pour permettre le fonctionnement de l'amplificateur différentiel 1141.

L'amplificateur différentiel 1141 commence à fonctionner dès que la tension d'alimentation VCC atteint 1,1V, à une telle tension, cet amplificateur possède un temps de réaction sensiblement égal à 50μs. Cependant, l'amplificateur différentiel 1141 ne peut pas effectuer de comparaison tant que la tension d'alimentation VCC n'a pas atteint 1,3V, du fait qu'aucune tension de référence VBGP n'est appliquée sur la seconde entrée 11412 de l'amplificateur différentiel 1141. En effet, la cellule BANDGAP 113 commence à délivrer la tension de référence VBGP de 1,2V seulement quand la tension d'alimentation VCC atteint 1,3V.

Cette solution de l'art antérieur présente l'inconvénient de ne générer aucun signal de réinitialisation lorsque la tension d'alimentation chute rapidement (en moins de 1μs) à un niveau très faible (tension d'alimentation inférieure à 2,4V).

Pour remédier à ce problème, il est traditionnellement envisagé de compléter le détecteur (PFD) 10 précité avec une grosse capacité (non représentée) de plusieurs μF. Cette capacité, qui est montée à l'extérieur du détecteur (PFD) 10, permet de ralentir la chute de la tension d'alimentation VCC. Cette technique permet ainsi au détecteur (PFD) 10 de générer un signal de réinitialisation lorsque la tension d'alimentation VCC chute à un niveau inférieur à 2,4V et avant que celle-ci ne devienne insuffisante (<1,3V) pour assurer le fonctionnement de l'amplificateur différentiel 1141.

Cependant, cette technique connue présente l'inconvénient de nécessiter d'une capacité qui est coûteuse et encombrante du fait de l'absence d'intégration au circuit imprimé.

## 3. Objectifs de l'invention

L'invention a notamment pour objectif de pallier ces inconvénients de l'art antérieur.

Plus précisément, un objectif de l'invention est de fournir une nouvelle technique permettant de générer un signal de réinitialisation même lorsque la tension d'alimentation chute rapidement à un niveau très faible (typiquement inférieur à 1,4V). Ainsi, et contrairement au détecteur (PFD) classique du type de celui de la figure 1, l'invention permet de générer un signal de réinitialisation en cas de perturbation brutale de la tension d'alimentation, par exemple si la tension d'alimentation chute à 0V en 500ns et remonte à un niveau suffisant en quelques centaines de μs. D'un point de vue théorique, l'invention génère même un signal de réinitialisation pour une chute et une remontée de la tension d'alimentation se produisant sur une durée de 5ns. Par « chute rapide », on entend ici, et dans tout le document, une chute de tension trop rapide pour permettre la génération d'un signal de réinitialisation par un détecteur (PFD) classique du type de celui de la figure 1.

Un autre objectif de l'invention est de proposer une telle technique qui soit adaptée à toutes les tensions d'alimentation standards des circuits intégrés actuels.

L'invention a aussi pour objectif de fournir une telle technique qui ne conduise pas à une augmentation de l'encombrement du circuit imprimé.

L'invention a encore pour objectif de proposer une telle technique qui soit simple et peu coûteuse à mettre en oeuvre.

## 4. Caractéristiques essentielles de l'invention

Ces objectifs, ainsi que d'autres qui apparaîtront par la suite, sont atteints à l'aide d'un dispositif de réinitialisation comprenant des moyens de détection d'une chute d'une tension d'alimentation reçue par le dispositif et des moyens de génération d'un signal de réinitialisation, activés après qu'une chute de la tension d'alimentation a été détectée par les moyens de détection.

Selon l'invention, les moyens de détection comprennent au moins un moyen de contrôle comprenant un élément de commande sur lequel est appliquée directement une première tension de commande, égale à la différence entre ladite tension d'alimentation et une première tension de décalage prédéterminée. Ledit au moins un moyen de contrôle comprend un premier moyen de contrôle comprenant lui-même un premier transistor formant un premier interrupteur et coopérant avec des moyens de stockage d'énergie compris dans lesdits moyens de détection. Selon l'invention, le placement dudit premier transistor dans un état passant, dans lequel ledit premier transistor autorise lesdits moyens de stockage d'énergie à libérer une énergie, est conditionné par le passage de ladite première tension de commande en dessous d'un premier seuil.

Ainsi, l'invention repose sur une approche tout à fait nouvelle et inventive de la génération d'un signal de réinitialisation d'un circuit intégré. En effet, une des difficultés solutionnées par l'invention réside en particulier dans le fait que le moyen de contrôle est capable de détecter une chute rapide (par exemple 500ns) d'une tension d'alimentation à un niveau très faible (par exemple 1,3V), et le cas échéant d'activer les moyens de génération pour générer un signal de réinitialisation, et ce, contrairement à la technique de l'art antérieur précitée, sans une capacité coûteuse et encombrante.

Pour ce faire, on utilise un moyen de contrôle commandé par une tension de commande qui, contrairement à la technique connue précitée (cf. figure 1), n'est pas une tension générée en sortie d'un amplificateur différentiel. Par conséquent, la tension de commande selon l'invention est générée plus rapidement, en ce sens qu'elle n'est pas dépendante du temps de réaction (temps pour générer une tension de commande) (généralement supérieur à 1μs) de l'amplificateur différentiel. En outre, la tension de commande selon l'invention peut être générée même lorsque la tension d'alimentation est inférieure à un seuil (par exemple 1,3V) en dessous duquel l'amplificateur différentiel de la solution de l'art antérieur ne génère aucune tension de commande.

Si le moyen de contrôle selon l'invention peut être mis en oeuvre de façon externe au circuit, il est préférentiellement intégré au circuit. En effet, dans ce cas, il est simple à mettre en oeuvre et pour un faible coût.

Avantageusement, ladite tension de décalage prédéterminée est égale à une tension de seuil d'un transistor MOS compris dans ledit dispositif.

Dans un premier mode de réalisation avantageux de l'invention, ledit premier transistor (TP3) est un transistor MOS de type P.

Préférentiellement, ledit premier seuil est égal à la différence entre une tension déterminée appliquée sur une source dudit premier transistor et une tension de seuil dudit premier transistor.

Avantageusement, ladite première tension de décalage prédéterminée, notée VX1. est telle que : $0 \leq VX1 < VCCn - (VS - VT)$

où

VCCn est une valeur nominale de ladite tension d'alimentation ;

VT est une tension de seuil dudit premier transistor ; et VS est une tension déterminée appliquée sur une source dudit premier transistor.

De façon préférentielle, lesdits moyens de stockage d'énergie comprennent un deuxième transistor utilisé comme capacité de filtrage.

Dans un second mode de réalisation avantageux de l'invention, lesdits moyens de détection comprennent un second moyen de contrôle comprenant lui-même un troisième transistor MOS de type N formant un second interrupteur et coopérant avec une première source de courant comprise dans lesdits moyens de détection, ledit troisième transistor comprenant un élément de commande sur lequel est appliquée une seconde tension de commande, égale à la différence entre ladite tension d'alimentation et une seconde tension de décalage prédéterminée, de sorte que :

- si ladite seconde tension de commande est supérieure à un second seuil, ledit troisième transistor est dans un état passant, dans lequel ledit troisième transistor empêche un courant généré par ladite première source de courant d'atteindre lesdits moyens de génération ;

- si ladite seconde tension de commande est inférieure ou égale audit second seuil, ledit troisième transistor est dans un état bloquant, dans lequel ledit troisième transistor dirige le courant généré par ladite première source de courant vers lesdits moyens de génération d'un signal de réinitialisation, de façon à activer lesdits moyens de génération.

Préférentiellement, ledit second seuil est égal à une tension de seuil dudit troisième transistor.

Avantageusement, ladite seconde tension de décalage prédéterminée, notée VX2, est telle que : $0 \leq VX2 < VCCn - VT$

où

VCCn est une valeur nominale de ladite tension d'alimentation ; et

VT est une tension de seuil dudit troisième transistor.

De façon préférentielle, ladite source de courant comprend un miroir de courant alimenté par ladite tension d'alimentation.

De façon avantageuse, ledit troisième transistor comprend :

- une grille constituant ledit élément de commande du troisième transistor ;
- une source reliée à la masse ;
- un drain relié à un point milieu entre ladite première source de courant et lesdits moyens de génération.

Dans un mode de réalisation préférentiel de l'invention, lesdits moyens de détection comprennent ledit premier moyen de contrôle et ledit second moyen de contrôle, ledit premier seuil étant inférieur audit second seuil.

Dans un troisième mode de réalisation avantageux de l'invention, lesdits moyens de détection comprennent en outre un troisième moyen de contrôle comprenant lui-même :

- des moyens de comparaison d'une tension proportionnelle à ladite tension d'alimentation avec une tension de référence déterminée, lesdits moyens de comparaison générant une tension résultante qui est fonction du résultat de la comparaison ;
- un quatrième transistor formant un troisième interrupteur et coopérant avec une deuxième source de courant, confondue ou non avec ladite première source de courant, ledit quatrième transistor comprenant un élément de commande sur lequel est appliquée ladite tension résultante, de sorte que :

   o si ladite tension résultante est supérieure à un troisième seuil, ledit quatrième transistor est dans un état passant, dans lequel ledit quatrième transistor empêche un courant généré par ladite deuxième source de courant d'atteindre lesdits moyens de génération ;
   o si ladite tension résultante est inférieure ou égale audit troisième seuil, ledit quatrième transistor est dans un état bloquant, dans lequel ledit quatrième transistor dirige le courant généré par ladite deuxième source de courant vers lesdits moyens de génération d'un signal de réinitialisation, de façon à activer lesdits moyens de génération.

Ainsi, la technique connue précitée (cf. figure 1), à laquelle correspond ce troisième moyen de contrôle, peut être mise en oeuvre en parallèle du premier et/ou du second moyen de contrôle selon l'invention. De cette façon, on augmente la plage de valeurs dans laquelle on peut détecter une chute de la tension d'alimentation.

Préférentiellement, ledit second seuil est inférieur audit troisième seuil.

Avantageusement, ledit premier seuil est inférieur audit troisième seuil.

De façon préférentielle, le quatrième transistor est monté par rapport au troisième transistor de sorte que ledit second interrupteur formé par le troisième transistor se comporte comme un interrupteur maître vis-à-vis du troisième interrupteur formé par le quatrième transistor, de sorte que si le troisième transistor est dans ledit état bloquant, lesdits moyens de génération sont activés quel que soit l'état du quatrième transistor.

De façon avantageuse, ledit quatrième transistor comprend :

- une grille constituant ledit élément de commande du quatrième transistor ;
- une source reliée au drain du troisième transistor ;
- un drain relié audit point milieu.

L'invention concerne également un circuit électronique comprenant un dispositif de réinitialisation tel que décrit ci-dessus.

**5. Liste des figures**

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 présente le schéma d'un dispositif de réinitialisation classique permettant de détecter une chute d'une tension d'alimentation ;
- la figure 2 présente le schéma d'un dispositif de réinitialisation selon un mode de réalisation préférentiel de l'invention ;

**6. Description d'un mode de réalisation de l'invention**

Le principe général de l'invention repose sur l'utilisation d'une tension de commande, égale à la différence entre la tension d'alimentation et une tension de décalage prédéterminée, pour détecter une chute rapide de la tension d'alimentation à un niveau faible. Cette tension de commande actionne au moins un transistor. Ce dernier permet d'activer ou non la génération d'un signal de réinitialisation.

On présente tout d'abord, en relation avec la figure 1, un exemple de dispositif de réinitialisation (ou détecteur de chute d'alimentation (PFD)) classique 10, comprenant des moyens 11 de détection et des moyens 12 de génération.

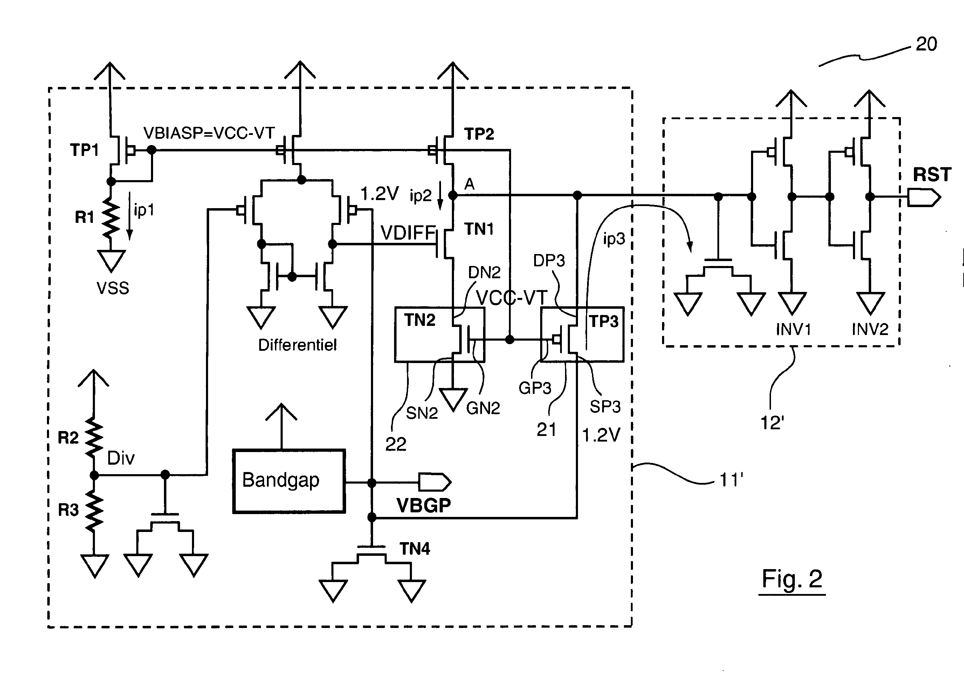

Comme on le verra en relation avec la figure 2, le dispositif de réinitialisation classique 10 peut servir de base pour la réalisation d'un dispositif de réinitialisation selon un mode de réalisation préférentiel de l'invention. Dans ce cas, des moyens de contrôle spécifiques à l'invention qui reçoivent une tension de commande, égale à la différence entre la tension d'alimentation et une tension de décalage prédéterminée, permettent d'activer la génération d'un signal de réinitialisation lorsque la tension d'alimentation chute rapidement à un niveau faible.

Les moyens de détection 11 comprennent des moyens de comparaison 114 d'une tension délivrée par des moyens de pondération 112 avec une tension délivrée par une cellule BANDGAP 113.

Les moyens de pondération 112 fournissent une tension pondérée div qui est proportionnelle à la tension d'alimentation VCC. Ces moyens de pondération 112 comprennent une première et une seconde résistance de pondération R2, R3 de valeurs égales, qui sont associées en série. La première résistance de pondération R2 est reliée à la tension d'alimentation VCC. La seconde résistance de pondération R3 est reliée, quant à elle, au potentiel de référence VSS (généralement égal à 0V). La tension pondérée div est la tension aux bornes de la seconde résistance de pondération R3. Elle est donc proportionnelle à la tension d'alimentation VCC selon un rapport de proportionnalité égal à la seconde résistance de pondération R3 sur le rapport de la somme des première et seconde résistances de pondération R2, R3 (la valeur de la résistance R2 étant égale à celle de la résistance R3, la tension pondérée div est donc égale à la moitié de la tension d'alimentation VCC). Les moyens de pondération 112 comprennent également un transistor 1121 monté en capacité (la tension pondérée div est appliquée sur la grille, le drain et la source étant connectés au potentiel de référence VSS). La fonction de cette capacité est de filtrer le bruit de façon à empêcher l'activation intempestive d'un signal de réinitialisation.

La cellule BANDGAP 113 est alimentée en entrée 1131 par la tension d'alimentation VCC. Cette cellule 113 commence à délivrer en sortie 1132 une tension de référence VBGP de 1,2V dès que la tension d'alimentation VCC atteint 1,3V. Un transistor TN4 est monté en parallèle à la sortie 1132 de la cellule BANDGAP 113. Ce transistor TN4, monté en capacité (la tension de référence VBGP est appliquée sur la grille, le drain et la source étant connectés au potentiel de référence VSS), permet de filtrer le bruit de façon à empêcher l'activation intempestive d'un signal de réinitialisation.

Les moyens de comparaison 114 comprennent un amplificateur différentiel 1141, alimenté par la tension d'alimentation VCC, dont une première entrée 11411 reçoit la tension pondérée div et une seconde entrée 11412 reçoit la tension de référence VBGP. La sortie 11413 (du côté de la seconde entrée) de l'amplificateur 1141 délivre une tension résultante VDIFF qui est appliquée sur la grille GN1 du transistor TN1, de sorte que l'amplificateur différentiel 1141 contrôle l'état (passant ou bloquant) du transistor TN1, ainsi que le courant ip2 le traversant dans l'état passant.

Le transistor TN1, dont la source SN1 est reliée au potentiel de référence VSS et dont le drain DN1 est relié à un point milieu A, forme un interrupteur 115.

Si le transistor TN1 est rendu passant par la tension résultante VDIFF (égale pour ce faire à la tension d'alimentation VCC), alors le potentiel du point milieu A est sensiblement égale au potentiel de référence VSS, soit 0V. Ainsi, les moyens de génération 12 du signal de réinitialisation RST ne sont pas activés. La tension résultante VDIFF est égale à la tension d'alimentation VCC lorsque la tension pondérée div est supérieure à la tension de référence VBGP (de 1,2V), autrement dit, lorsque la tension d'alimentation VCC est supérieure à 2,4V.

Si le transistor TN1 est bloqué par la tension résultante VDIFF (égale pour ce faire au potentiel de référence VSS), alors le courant ip2 de la source de courant 111 charge le potentiel du point milieu A, de sorte que celui-ci devient non nul et positif. Ainsi, les moyens de génération 12 du signal de réinitialisation RST sont activés. La tension résultante VDIFF est égale au potentiel de référence VSS lorsque la tension pondérée div est inférieure à la tension de référence VBGP (de 1,2V), autrement dit, lorsque la tension d'alimentation VCC est inférieure ou égale à 2,4V.

Les moyens de détection 11 comprennent en outre une source de courant 111 comprenant elle-même un premier transistor TP1 monté en diode (la grille GP1 est connectée au drain DP1). La tension d'alimentation VCC est appliquée sur la source SP1 du premier transistor TP1. Le drain DP1 de ce dernier est relié à une résistance R1 qui est, quant à elle, connectée au potentiel de référence VSS. La valeur de l'intensité du courant ip1 qui circule dans le premier transistor TP1 est imposée par la valeur de la résistance R1. La grille GP1 du premier transistor TP1 est connectée à la grille GP2 d'un second transistor TP2. Les premier et second transistors forment un miroir de courant, selon lequel, le courant ip1 circulant sur le drain DP1 du premier transistor TP1 est égal au courant ip2 circulant sur le drain DP2 du second transistor TP2. La tension d'alimentation VCC est appliquée sur la source SP2 du second transistor TP2. Le drain DP2 du second transistor TP2 est relié au point milieu A.

Ainsi, le point milieu A est un point de connexion commun au drain DP2 du transistor TP2, au drain DN1 du transistor TN1 et à l'entrée 121 des moyens de génération 12.

Les moyens de génération 12 sont activés lorsque le point milieu A est chargé (potentiel non nul et positif). Ces moyens de génération 12 comprennent un premier et un second inverseur INV1, INV2 (chacun à base de deux transistors) montés en série. Ce montage de base permet d'une part de mettre en forme le signal de réinitialisation délivré en sortie 122 et d'autre part d'augmenter le facteur de charge (« Fan-Out », en anglais). Les moyens de génération 12 comprennent en outre un transistor 123 monté en parallèle à l'entrée 121 de ces moyens 12. Ce transistor 123, monté en capacité (la grille étant connectée au point milieu A, le drain et la source étant connectés au potentiel de référence VSS), permet de filtrer le bruit de façon à empêcher l'activation intempestive d'un signal de réinitialisation.

On va décrire en relation avec la **figure 2** un dispositif de réinitialisation 20 selon un mode de réalisation préférentiel de l'invention.

Dans ce mode de réalisation, le dispositif de réinitialisation 20 selon l'invention comprend :

- des moyens de détection 11' comprenant, outre les moyens de détection 11 décrits en relation avec la figure 1, des premiers et seconds moyens de contrôle spécifiques à l'invention ; et

- des moyens de génération 12', identiques aux moyens de génération 12 décrits en relation avec la figure 1.

Tous les éléments de la figure 1 conservent la même référence quand ils apparaissent sur la figure 2.

Les premiers moyens de contrôle 21 comprennent un transistor TP3 recevant directement sur sa grille GP3 une première tension de commande VBIASP (VBIASP est délivrée par la grille GP1 du transistor TP1), égale à la différence entre la tension d'alimentation VCC et une première tension de décalage VX1. Dans ce mode de réalisation préférentiel, la première tension de décalage VX1 est la tension de seuil VTP1 de la diode équivalente du transistor TP1. Cette tension VBIASP permet de commander l'état (passant ou bloquant) du transistor TP3, dont le drain DP3 est relié au point milieu A et dont la source SP3 est reliée à la sortie 1132 de la cellule BANDGAP 113 (délivrant la tension VBGP).

Dans ce mode de réalisation préférentiel, le transistor TP3 est un transistor MOS, de type P possédant une tension de seuil VTP3 (généralement de -0,7V) (non représentée).

Ainsi, pour placer le transistor TP3 dans un état bloquant, la tension de commutation VGS (non représentée), égale à la différence entre la tension (VBIASP) appliquée sur la grille GP3 du transistor TP3 et la tension (VBGP) appliquée sur la source SP3 du transistor TP3, doit être supérieure à la tension de seuil VTP3 du transistor TP3. Par conséquent, le transistor TP3 est bloqué par la première tension de commande VBIASP lorsque celle-ci est supérieure à un premier seuil, égal à la somme entre la tension de référence VBGP (par exemple de 1,2V) et la tension de seuil VTP3 (par exemple de -0,7V) du transistor TP3, soit par exemple 0,5V. Autrement dit, le transistor TP3 est bloqué lorsque la tension d'alimentation VCC est supérieure à un second seuil, égal à la somme de trois tensions qui sont respectivement la première tension de décalage VX1 (par exemple de 0,7V), la tension de référence VBGP (par exemple de 1,2V) et la tension de seuil VTP3 (par exemple de -0,7V) du transistor TP3, soit par exemple 1,2V.

À l'inverse, le transistor TP3 est rendu passant par la première tension de commande VBIASP lorsque celle-ci est inférieure ou égale au premier seuil (par exemple de 0,5V) décrit ci-dessus. Autrement dit, le transistor TP3 est rendu passant lorsque la tension d'alimentation VCC est inférieure ou égale au second seuil (par exemple de 1,2V) décrit ci-dessus.

On notera que la première tension de décalage VX1 est telle que :

$$0 \leq VX1 < VCCn - (VS - VTP3)$$

où

- VCCn est une valeur nominale (par exemple de 3V) de la tension d'alimentation VCC ;
- VTP3 est la tension de seuil (par exemple de -0,7V) du transistor TP3 ; et
- VS est la tension appliquée sur la source SP3 du transistor TP3 (dans ce mode de réalisation, VS est la tension de référence VBGP (par exemple de 1,2V)).

Si le transistor TP3 est bloqué par la tension de commande VBIASP (VBIASP supérieure à 0,5V), alors la capacité équivalente au transistor TN4 (montée en parallèle à la sortie 1132 de la cellule 113) se charge avec la tension de référence VBGP (par exemple de 1,2V).

Si le transistor TP3 est rendu passant par la tension de commande VBIASP (VBIASP inférieure ou égale à 0,5V), alors le courant ip3 de la capacité équivalente au transistor TN4 charge le potentiel du point milieu A, de sorte que celui-ci devienne non nul et positif. Ainsi, les moyens de génération 12 du signal de réinitialisation RST sont activés.

Ces premiers moyens de contrôle 21 permettent donc d'activer la génération d'un signal de réinitialisation RST lorsque la tension d'alimentation VCC est inférieure ou égale à 1,2V (même si VCC égale à 0V).

Les seconds moyens de contrôle 22 comprennent un transistor TN2 recevant directement sur sa grille GP2 une seconde tension de commande VBIASP (VBIASP est délivrée par la grille GP1 du transistor TP1), égale à la différence entre la tension d'alimentation VCC et une seconde tension de décalage VX2. Dans ce mode de réalisation préférentiel, la seconde tension de décalage VX2 est la tension de seuil VTP1 de la diode équivalente du transistor TP1. Cette tension VBIASP permet de commander l'état (passant ou bloquant) du transistor TN2, dont la source SN2 est reliée au potentiel de référence VSS et dont le drain DN2 est relié à la source SN1 du transistor TN1.

Dans ce mode de réalisation préférentiel, le transistor TN2 est un transistor MOS, de type N possédant une tension de seuil VTN2 (généralement de +0,7V) (non représentée).

Ainsi, pour placer le transistor TN2 dans un état passant, la tension de commutation VGS (non représentée), égale à la différence entre la tension (VBIASP) appliquée sur la grille GN2 du transistor TN2 et la tension (VSS) appliquée sur la source SN2 du transistor TN2, doit être supérieure à la tension de seuil VTN2 du transistor TN2. Par conséquent, le transistor TN2 est rendu passant par la seconde tension de commande VBIASP lorsque celle-ci est supérieure à un troisième seuil, égal à la somme entre le potentiel de référence VSS (par exemple de 0V) et la tension de seuil VTN2 (par exemple de +0,7V) du transistor TN2, soit par exemple 0,7V. Autrement dit, le transistor TN2 est rendu passant lorsque la tension d'alimentation VCC est supérieure à un quatrième seuil, égal à la somme de trois tensions qui sont respectivement la seconde tension de décalage VX2 (par exemple de 0,7V), le potentiel de référence VSS (par exemple de 0V) et la tension de seuil VTN2 (par exemple de +0,7V) du transistor TN2, soit par exemple 1,4V.

À l'inverse, le transistor TN2 est bloqué par la seconde tension de commande VBIASP lorsque celle-ci est inférieure ou égale au troisième seuil (par exemple de 0,7V) décrit ci-dessus. Autrement dit, le transistor TN2 est bloqué lorsque la tension d'alimentation VCC est inférieure ou égale au quatrième seuil (par exemple de 1,4V) décrit ci-dessus.

On notera que la seconde tension de décalage VX2 est telle que :

$$0 \le VX2 < VCCn - VTN2$$

où

- VCCn est une valeur nominale (par exemple de 3V) de la tension d'alimentation VCC ;
- VTN2 est la tension de seuil (par exemple de +0,7V) du transistor TN2.

Si le transistor TN2 est rendu passant par la tension de commande VBIASP (VBIASP supérieure à 0,7V), alors l'état (passant ou bloquant) du transistor TN1 autorise ou non l'activation des moyens de génération 12 du signal de réinitialisation RST, tel que décrit en relation avec la figure 1.

Si le transistor TN2 est bloqué par la tension de commande VBIASP (VBIASP inférieure ou égale à 0,7V), alors, quel que soit l'état du transistor TN1, le courant ip2 de la source de courant 111 charge le potentiel du point milieu A, de sorte que celui-ci devienne non nul et positif. Ainsi, les moyens de génération 12 du signal de réinitialisation RST sont activés.

Ces seconds moyens de contrôle 22 permettent donc d'activer la génération d'un signal de réinitialisation RST lorsque la tension d'alimentation VCC est inférieure ou égale à 1,4V.

En résumé, le dispositif de réinitialisation d'un circuit intégré à partir d'une détection d'une chute d'une tension d'alimentation, tel que proposé par l'invention, présente de nombreux avantages, dont une liste non exhaustive est donnée ci-dessous :

- amélioration de la rapidité de détection, en effet, l'invention permet de détecter une tension d'alimentation chutant en moins de 1μs à un niveau faible ;
- amélioration de la dynamique de détection, en effet, l'invention permet de détecter une chute d'une tension d'alimentation sur une plage de valeurs plus grande ;

Bien entendu, l'invention n'est pas limitée à l'exemple de réalisation mentionné ci-dessus.

En particulier, l'Homme du Métier pourra, en fonction de la dynamique de détection souhaitée, utiliser les premier et second moyens de contrôle de l'invention seuls ou en combinaison.

De même, la tension de commande des moyens de contrôle de l'invention peut être réalisée de toute autre manière, à partir notamment d'un pont diviseur résistif.

D'une façon générale, dans d'autres exemples de réalisation, les valeurs de VCCn, VTP3, VTN2, VTP1, et VBGP peuvent être différentes de celles données dans le cas du mode de réalisation préférentiel exposé ci-dessus.

Bien que l'invention ait été décrite ci-dessus en relation avec un nombre limité de modes de réalisation, l'homme du métier, à la lecture de la présente description, comprendra que d'autres modes de réalisation peuvent être imaginés sans sortir du cadre de la présente invention. En conséquence, la portée de l'invention n'est limitée que par les revendications ci-jointes.

**Revendications**

1. Dispositif de réinitialisation, du type comprenant des moyens de détection (11') d'une chute d'une tension d'alimentation (VCC) reçue par ledit dispositif, générant une tension d'activation (A) après qu'une chute de ladite tension d'alimentation (VCC) a été détectée, et des moyens de génération (12') d'un signal de réinitialisation (RST), activés par ladite tension d'activation,
**caractérisé en ce que** lesdits moyens de détection comprennent au moins un moyen de contrôle (21,22) comprenant un élément de commande sur lequel est appliquée directement une première tension de commande (VBIASP), égale à la différence entre ladite tension d'alimentation (VCC) et une première tension de décalage prédéterminée,
**en ce que** ledit au moins un moyen de contrôle (21,22) comprend un premier moyen de contrôle (21) comprenant lui-même un premier transistor (TP3) formant un premier interrupteur et coopérant avec des moyens de stockage d'énergie (TN4) compris dans lesdits moyens de détection,
et **en ce que** le placement dudit premier transistor dans un état passant, dans lequel ledit premier transistor autorise lesdits moyens de stockage d'énergie (TN4) à libérer une énergie, est conditionné par le passage de ladite première tension de commande (VBIASP) en dessous d'un premier seuil.

2. Dispositif selon la revendication 1, **caractérisé en ce que** ladite tension de décalage prédéterminée est égale à une tension de seuil (VT) d'un transistor MOS compris dans ledit dispositif.

3. Dispositif selon l'une quelconque des revendications 1 et 2, **caractérisé en ce que** ledit premier transistor (TP3) est un transistor MOS de type P,
et **en ce que** ledit premier seuil est égal à la différence entre une tension déterminée (VBGP) appliquée sur une source dudit premier transistor (TP3) et une tension de seuil (VT) dudit premier transistor (TP3).

4. Dispositif selon l'une quelconque des revendications 1 à 3, **caractérisé en ce que** ladite première tension de décalage prédéterminée, notée VX1, est telle que : $0 \leq VX1 < VCCn - (VS - VT)$
où
VCCn est une valeur nominale de ladite tension d'alimentation (VCC) ;
VT est une tension de seuil dudit premier transistor (TP3) ; et
VS est une tension déterminée (VBGP) appliquée sur une source dudit premier transistor (TP3).

5. Dispositif selon l'une quelconque des revendications 1 à 4, **caractérisé en ce que** lesdits moyens de stockage d'énergie comprennent un deuxième transistor (TN4) utilisé comme capacité de filtrage.

6. Dispositif selon l'une quelconque des revendications 1 à 5, **caractérisé en ce que** ledit au moins un moyen de contrôle comprend en outre un second moyen de contrôle comprenant lui-même un troisième transistor (TN2) MOS de type N formant un second interrupteur et coopérant avec une première source de courant comprise dans lesdits moyens de détection, ledit troisième transistor comprenant un élément de commande sur lequel est appliquée une seconde tension de commande (VBIASP), égale à la différence entre ladite tension d'alimentation (VCC) et une seconde tension de décalage prédéterminée,
et **en ce que** le placement dudit troisième transistor dans un état bloquant, dans lequel ledit troisième transistor dirige un courant généré par ladite première source de courant vers lesdits moyens de génération d'un signal de réinitialisation (RST), est conditionné par le passage de ladite seconde tension de commande (VBIASP) en dessous d'un second seuil.

7. Dispositif selon la revendication 6, **caractérisé en ce que** ledit second seuil est égal à une tension de seuil (VT) dudit troisième transistor (TN2).

8. Dispositif selon l'une quelconque des revendications 6 et 7, **caractérisé en ce que** ladite seconde tension de décalage prédéterminée, notée VX2, est telle que: $0 \leq VX2 < VCCn - VT$
où
VCCn est une valeur nominale de ladite tension d'alimentation (VCC) ; et

VT est une tension de seuil dudit troisième transistor (TN2).

9.  Dispositif selon l'une quelconque des revendications 6 à 8, **caractérisé en ce que** ladite source de courant comprend un miroir de courant alimenté par ladite tension d'alimentation (VCC).

10.  Dispositif selon l'une quelconque des revendications 6 à 9, **caractérisé en ce que** ledit troisième transistor (TN2) comprend :

    - une grille constituant ledit élément de commande du troisième transistor ;
    - une source reliée à la masse ;
    - un drain relié à un point milieu entre ladite première source de courant et lesdits moyens de génération.

11.  Dispositif selon l'une quelconque des revendications 1 à 10, **caractérisé en ce que** lesdits moyens de détection comprennent ledit premier moyen de contrôle et ledit second moyen de contrôle, et **en ce que** ledit premier seuil est inférieur audit second seuil.

12.  Dispositif selon l'une quelconque des revendications 1 à 11, **caractérisé en ce que** lesdits moyens de détection comprennent en outre un troisième moyen de contrôle comprenant lui-même :

    - des moyens de comparaison d'une tension proportionnelle à ladite tension d'alimentation (div) avec une tension de référence déterminée (VBGP), lesdits moyens de comparaison générant une tension résultante (VDIFF) qui est fonction du résultat de la comparaison ;
    - un quatrième transistor (TN1) formant un troisième interrupteur et coopérant avec une deuxième source de courant, confondue ou non avec ladite première source de courant, ledit quatrième transistor comprenant un élément de commande sur lequel est appliquée ladite tension résultante (VDIFF),

    et **en ce que** le placement dudit quatrième transistor dans un état bloquant, dans lequel ledit quatrième transistor dirige un courant généré par ladite deuxième source de courant vers lesdits moyens de génération d'un signal de réinitialisation (RST), est conditionné par le passage de ladite tension résultante (VDIFF) en dessous d'un troisième seuil.

13.  Dispositif selon la revendication 12 uniquement quand elle dépend de l'une quelconque des revendications 6 à 11, **caractérisé en ce que** ledit second seuil est inférieur audit troisième seuil.

14.  Dispositif selon la revendication 12 uniquement quand elle dépend de l'une quelconque des revendications 1 à 6, **caractérisé en ce que** ledit premier seuil est inférieur audit troisième seuil.

15.  Dispositif selon la revendication 12 uniquement quand elle dépend de l'une quelconque des revendications 6 à 11, **caractérisé en ce que** le quatrième transistor (TN1) est monté en série avec ledit troisième transistor (TN2), ledit troisième transistor (TN2) agissant comme un interrupteur maître vis-à-vis du quatrième transistor (TN1).

16.  Dispositif selon la revendication 15, **caractérisé en ce que** ledit quatrième transistor (TN1) comprend :

    - une grille constituant ledit élément de commande du quatrième transistor ;
    - une source reliée au drain du troisième transistor (TN2) ;
    - un drain relié audit point milieu.

17.  Circuit électronique **caractérisé en ce qu'**il comprend un dispositif de réinitialisation selon l'une quelconque des revendications 1 à 16.

**Claims**

1.  Reset device, of the type comprising detection means (11') for detecting of a drop in a power supply voltage (VCC) received by the said device, generating an activation voltage (A) after a drop in the said power supply voltage (VCC) has been detected, and means (12') for generating a reset signal (RST), activated by the said activation voltage, **characterised in that** the said detection means comprise at least one control means (21, 22) comprising a control element on which there is applied directly a first control voltage (VBIASP), equal to the difference between the said power supply voltage (VCC) and a first predetermined offset voltage, **in that** the said at least one control means (21, 22) comprises a first control means (21) itself comprising a first transistor (TP3) forming a first switch and co-operating with energy storing means (TN4) included within the said detection means, and **in that** the said first transistor is in a conducting state, in which the said first transistor enables the said energy storage means (TN4) to release the said energy, if the said first control voltage (VBIASP) is less than a first threshold.

2.  Device according to claim 1, **characterised in that** the said predetermined offset voltage is equal to a threshold voltage (VT) of a MOS transistor included within the said device.

3.  Device according to anyone of claims 1 and 2, **char-**

**acterised in that** the said first transistor (TP3) is a MOS transistor of type P, and **in that** the said first threshold is equal to the difference between a determined voltage (VBGP) applied to a source of the said first transistor (TP3) and a threshold voltage (VT) of the said first transistor (TP3).

4. Device according to any one of claims 1 to 3, **characterised in that** the said first predetermined offset voltage, denoted VX1, is such that
$0 \leq VX1 < VCC_n - (VS - VT)$
where:

VCC$_n$ is a nominal value of the said power supply voltage (VCC);
VT is a threshold voltage of the said first transistor (TP3); and
VS is a determined voltage (VBGP) applied to a source of the said first transistor (TP3).

5. Device according to any one of claims 1 to 4, **characterised in that** the said energy is used as a filtering capacitor.

6. Device according to any one of claims 1 to 5, **characterised in that** the said at least one control means further comprises a second control means itself comprising a third MOS transistor (TN2) of type N, forming a second switch and co-operating with a first current source included within the said detections means, the said third transistor comprising a command element to which a second control voltage (VBIASP) is applied, equal to the difference between the said power supply voltage (VCC) and a second predetermined offset voltage,
and **in that** the said third transistor is in a blocking state, in which the said third transistor directs a current generated by the said first current source towards the said means for generating a reset signal (RST), if the said second control voltage (VBIASP) is less than a second threshold.

7. Device according to claim 6, **characterised in that** the said second threshold is equal to a threshold voltage (VT) of the said third transistor (TN2).

8. Device according to anyone of claims 6 and 7, **characterised in that** the said second predetermined offset voltage, denoted VX2, is such that
$0 \leq VX2 < VCC_n - VT$
where:

VCC$_n$ is a nominal value of the said power supply voltage (VCC); and
VT is a threshold voltage of the said third transistor (TN2).

9. Device according to any one of claims 6 to 8, **char-**

**acterised in that** the said current source comprises a current mirror powered by the said power supply voltage (VCC).

10. Device according to any one of claims 6 to 9, **characterised in that** the said third transistor (TN2) comprises:

- a gate forming the said control element of the third transistor;
- a source connected to the ground; and
- a drain connected to a mid-point between the said first current source and the said generation means.

11. Device according to any one of claims 1 to 10, **characterised in that** the said detection means comprise the said first control means and the said second control means, and **in that** the said first threshold is less than the said second threshold.

12. Device according to any one of claims 1 to 11, **characterised in that** the said detection means further comprise a third control means which itself comprising:

- comparison means for comparing a voltage proportional to the said power supply voltage (div) with a predetermined reference voltage (VBGP), the said comparison means generating a resulting voltage (VDIFF) that depends on the result of the comparison;
- a fourth transistor (TN1) forming a third switch and co-operating with a second current source, that may or not be coincident with the said first current source, the said fourth transistor comprising a control element on which the said resulting voltage (VDIFF) is applied, and **in that** the said fourth transistor is in a blocking state, in which the said fourth transistor directs a current generated by the said second current source towards the said means for generating a reset signal (RST), if the said resulting voltage (VDIFF) is less than a third threshold.

13. Device according to claim 12, only when it is dependent on any one of claims 6 to 11, **characterised in that** the said second threshold is less than the said third threshold.

14. Device according to claim 12, only when it is dependent on any one of claims 1 to 6, **characterised in that** the said first threshold is less than the said third threshold.

15. Device according to claim 12, only when it is dependent on any one of claims 6 to 11, **characterised in that** the fourth transistor (TN1) is mounted in series with the said third transistor (TN2), the said third transistor (TN2) acting as a master switch with respect to the fourth transistor (TN1).

16. Device according to claim 15, **characterised in that** the said fourth transistor (TN1) comprises:

- a gate forming the said control element of the fourth transistor;
- a source connected to the drain of the third transistor (TN2); and
- a drain connected to the said mid-point.

17. Electronic circuit **characterised in that** it comprises a resetting device according to any one of claims 1 to 16.


**Patentansprüche**

1. Reset-Vorrichtung des Typs, die Erfassungsmittel (11') eines Abfallens einer Versorgungsspannung (VCC), die von der Vorrichtung empfangen wird, aufweist, die eine Aktivierungsspannung (A) erzeugt, nachdem ein Abfallen der Versorgungsspannung (VCC) erfasst wurde, und Mittel zum Erzeugen (12') eines Reset-Signals (RST), die von der Aktivierungsspannung aktiviert werden,
**dadurch gekennzeichnet, dass** die Erfassungsmittel mindestens ein Steuermittel (21, 22) aufweisen, das ein Steuerelement aufweist, auf das direkt eine erste Steuerspannung (VBIASP) angelegt wird, die gleich dem Unterschied zwischen der Versorgungsspannung (VCC) und einer ersten vorbestimmten Versatzspannung ist,
dass das mindestens eine Steuermittel (21, 22) ein erstes Steuermittel (21) aufweist, das selbst einen ersten Transistor (TP3) aufweist, der einen ersten Schalter bildet und mit Energiespeichermitteln (TN4) zusammenarbeitet, die in den Erfassungsmitteln enthalten sind,
und dass die Platzierung des ersten Transistors in einen Durchlasszustand, in dem der erste Transistor den Energiespeichermitteln (TN4) gestattet, eine Energie freizugeben, von dem Übergehen der ersten Steuerspannung (VBIASP) unter einen ersten Schwellenwert abhängt.

2. Vorrichtung nach Anspruch 1,
**dadurch gekennzeichnet, dass** die vorbestimmte Versatzspannung gleich einer Schwellenspannung (VT) eines MOS-Transistors ist, der in der Vorrichtung enthalten ist.

3. Vorrichtung nach einem der Ansprüche 1 und 2,
**dadurch gekennzeichnet, dass** der erste Transistor (TP3) ein MOS-Transistor des Typs (P) ist, und dass der erste Schwellenwert gleich dem Unterschied zwischen einer bestimmten Spannung (VBGP), die auf eine Quelle des ersten Transistors (TP3) angelegt wird, und einer Schwellenspannung (VT) des ersten Transistors (TP3) ist.

4. Vorrichtung nach einem der Ansprüche 1 bis 3,
**dadurch gekennzeichnet, dass** die erste vorbestimmte Versatzspannung, VX1 genannt, derart ist, dass: $0 \leq VX1 < VCCn - (VS - VT)$,
wobei VCCn ein Nennwert der Versorgungsspannung (VCC) ist;
VT eine Schwellenspannung des ersten Transistors (TP3) ist, und
VS eine bestimmte Spannung (VBGP) ist, die auf eine Quelle des ersten Transistors (TP3) angelegt wird.

5. Vorrichtung nach einem der Ansprüche 1 bis 4,
**dadurch gekennzeichnet, dass** die Energiespeichermittel einen zweiten Transistor (TN4) aufweisen, der als Filterkapazität verwendet wird.

6. Vorrichtung nach einem der Ansprüche 1 bis 5,
**dadurch gekennzeichnet, dass** das mindestens eine Steuermittel ferner ein zweites Steuermittel aufweist, das wiederum einen dritten MOS-Transistor (TN2) des Typs N aufweist, der einen zweiten Schalter bildet und mit einer ersten Stromquelle zusammenwirkt, die in den Erfassungsmitteln enthalten ist, wobei der dritte Transistor ein Steuerelement aufweist, an das eine zweite Steuerspannung (VBIASP) angelegt wird, die gleich dem Unterschied zwischen der Versorgungsspannung (VCC) und einer zweiten vorbestimmten Versatzspannung ist,
und dass das Platzieren des dritten Transistors in einen Sperrzustand, in dem der dritte Transistor einen von der ersten Stromquelle erzeugten Strom zu den Erzeugungsmitteln eines Reset-Signals (RST) leitet, von dem Übergehen der zweiten Steuerspannung (VBLASP) unter einen zweiten Schwellenwert abhängt.

7. Vorrichtung nach Anspruch 6,
**dadurch gekennzeichnet, dass** der zweite Schwellenwert gleich einer Schwellenspannung (VT) des dritten Transistors (TN2) ist.

8. Vorrichtung nach einem der Ansprüche 6 und 7,
**dadurch gekennzeichnet, dass** die zweite vorbestimmte Versatzspannung, VX2 genannt, derart ist, dass: $0 \leq VX2 < VCCn - VT$,
wobei
VCCn ein Nennwert der Steuerspannung (VCC) ist und
VT eine Schwellenspannung des dritten Transistors (TN2) ist.

9. Vorrichtung nach einem der Ansprüche 6 bis 8,

**dadurch gekennzeichnet, dass** die Stromquelle einen Stromspiegel aufweist, der von der Steuerspannung (VCC) geliefert wird.

10. Vorrichtung nach einem der Ansprüche 6 bis 9, **dadurch gekennzeichnet, dass** der dritte Transistor (TN2) Folgendes aufweist:

     - ein Gitter, das das Steuerelement des dritten Transistors bildet;
     - eine Quelle, die an die Masse gelegt ist;
     - einen Drain, der mit einem Mittenpunkt zwischen der ersten Stromquelle und den Erzeugungsmitteln verbunden ist.

11. Vorrichtung nach einem der Ansprüche 1 bis 10, **dadurch gekennzeichnet, dass** die Erfassungsmittel das erste Steuermittel und das zweite Steuermittel aufweisen, und dass der erste Schwellenwert kleiner ist als der zweite Schwellenwert.

12. Vorrichtung nach einem der Ansprüche 1 bis 11, **dadurch gekennzeichnet, dass** die Erfassungsmittel ferner ein drittes Steuermittel aufweisen, das selbst wiederum Folgendes aufweist:

     - Mittel zum Vergleichen einer zu der Versorgungsspannung (div) proportionalen Spannung mit einer bestimmten Bezugsspannung (VBGP), wobei die Vergleichsmittel eine Ergebnisspannung (VDIFF) erzeugen, die von dem Vergleichsergebnis abhängt;
     - einen vierten Transistor (TN1), der einen dritten Schalter bildet und mit einer zweiten Stromquelle zusammenwirkt, die mit der ersten Stromquelle zusammenfällt oder nicht, wobei der vierte Transistor ein Steuerelement aufweist, auf das die Ergebnisspannung (VDIFF) angelegt wird, und dass das Platzieren des vierten Transistors in einen Sperrzustand, in dem der vierte Transistor einen von der zweiten Stromquelle erzeugten Strom zu den Erzeugungsmitteln eines Reset-Signals (RST) leitet, von dem Übergehen der Ergebnisspannung (VDIFF) unter einen dritten Schwellenwert abhängt.

13. Vorrichtung nach Anspruch 12, nur wenn er von einem der Ansprüche 6 bis 11 abhängt, **dadurch gekennzeichnet, dass** der zweite Schwellenwert kleiner ist als der dritte Schwellenwert.

14. Vorrichtung nach Anspruch 12, nur wenn er von einem der Ansprüche 1 bis 6 abhängt, **dadurch gekennzeichnet, dass** der erste Schwellenwert kleiner ist als der dritte Schwellenwert.

15. Vorrichtung nach Anspruch 12, nur wenn er von einem der Ansprüche 6 bis 11 abhängt, **dadurch gekennzeichnet, dass** der vierte Transistor (TN1) in Serie mit dem dritten Transistor (TN2) installiert ist, wobei der dritte Transistor (TN2) als ein Hauptschalter gegenüber dem vierten Transistor (TN1) wirkt.

16. Vorrichtung nach Anspruch 15, **dadurch gekennzeichnet, dass** der vierte Transistor (TN1) Folgendes aufweist:

     - ein Gitter, das das Steuerelement des vierten Transistors bildet;
     - eine Quelle, die mit dem Drain des dritten Transistors (TN2) verbunden ist,
     - und einen Drain, der mit dem Mittenpunkt verbunden ist.

17. Elektronischer Schaltkreis, **dadurch gekennzeichnet, dass** er eine Reset-Vorrichtung nach einem der Ansprüche 1 bis 16 aufweist.

Fig. 1

Fig. 2

EP 1 672 795 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6515523 B